# EUROPEAN PATENT APPLICATION

(11) **EP 4 811 665 A1**
(43) Date of publication of application: **23.09.2026**
(21) Application number: 26161597.5
(22) Date of filing: 02.03.2026
(51) Int. Cl.: H03M 1/16, H03M 1/38

(54) **CAPACITIVELY-COUPLED CONTINUOUS-TIME INPUT PIPELINE ADC WITH DYNAMIC REFRESH AND CMRR DIGITAL ENHANCEMENT**

(30) Priority: 17.03.2025 US 202519081021
(71) Applicant: Avago Technologies International Sales Pte. Limited, Singapore 768923 (SG)
(72) Inventor: Ragab, Kareem Abdelghani Ibraheem Mohamed, Irvine, CA, 92620 (US); Chandrasekhar, Vinay, Irvine, CA, 92602 (US); Jiang, Xicheng, Irvine, CA, 92612 (US)
(74) Representative: Grünecker Patent- und Rechtsanwälte PartG mbB

(57) **Abstract**

An apparatus for analog-to-digital conversion comprising a first module with a comparator and digital-to-analog converters, and a second module with an amplifier. The apparatus implements input chopping by connecting capacitors to differential inputs through switches, and output chopping via an output chopper. Dynamic refresh is achieved using a switch to periodically connect differential inputs to a voltage reference. The apparatus further incorporates digital common-mode rejection ratio (CMRR) enhancement by processing signals from pseudo-differential first stage analog-to-digital converters.

## Description

### BACKGROUND

The present disclosure relates to analog-to-digital converters, and more particularly to a capacitively-coupled continuous-time input pipeline analog-to-digital converter with dynamic refresh and a method of analog-to-digital conversion.

Analog-to-digital converters (ADCs) play a crucial role in modern electronic systems by converting continuous analog signals into discrete digital representations. As technology advances, there is an increasing demand for ADCs with higher precision, lower power consumption, and improved performance in various applications such as biosignal sensing, audio processing, and wireless communications.

In the field of biosignal sensing, particularly for wearable health monitoring devices, ADCs face several challenges. These devices often need to process low-frequency signals with high accuracy while operating under strict power constraints. Additionally, they must manage large common-mode interference and maintain high input impedance to minimize the load on the signal source.

Traditional ADC architectures, such as sigma-delta (ΣΔ) converters, have been widely used for high-resolution applications. However, these designs can consume considerable power and may introduce undesirable latency in the signal path. Successive approximation register (SAR) ADCs offer an alternative approach with potentially lower power consumption, but they typically struggle to achieve the high resolution required for precise biosignal measurements.

Pipeline ADC architectures have emerged as a potential solution to balance the trade-offs between resolution, speed, and power consumption. By dividing the conversion process into multiple stages, pipeline ADCs can achieve high resolution while maintaining relatively low power consumption. However, implementing pipeline ADCs for continuous-time input signals presents additional challenges, particularly in maintaining the common-mode voltage at high-impedance nodes and managing noise introduced by sampling operations.

Capacitively-coupled input stages have been explored as a means to address some of these challenges. This approach can provide high input impedance. However, it introduces new complexities in managing charge leakage and maintaining stable operation over extended periods.

As wearable health monitoring devices become more prevalent, there is a growing need for ADC designs that can operate continuously for long durations while maintaining high accuracy and low power consumption. This requires innovative approaches to address issues such as drift, noise, and common-mode rejection in capacitively-coupled, continuous-time input ADCs.

The development of ADCs for biosignal sensing applications continues to be an active area of research, with ongoing efforts to optimize the balance between resolution, power consumption, and robustness to environmental factors. Advancements in this field have the potential to enable new capabilities in wearable health monitoring devices and other applications requiring high-precision, low-power analog-to-digital conversion.

Accordingly, there is a need in the art for an improved analog-to-digital converter.

### BRIEF DESCRIPTION OF DRAWINGS

The accompanying drawings, which form part of this specification, depict examples of the disclosure and, along with the description, illustrate the underlying principles of these examples. The detailed description is provided with reference to the accompanying figures. In the figures, the leading digit(s) of each reference number correspond to the figure where the reference number first appears. The figures are not drawn to scale, and certain proportions or elements may be exaggerated in some figures to enhance the clarity of specific features.

Non-limiting and non-exhaustive examples are described with reference to the following figures.
FIG. 1 illustrates an exemplary analog-to-digital converter architecture, in accordance with one or more embodiments of the disclosure.
FIG. 2 illustrates an exemplary timing diagram, in accordance with one or more embodiments of the disclosure.
FIG. 3 illustrates an exemplary analog-to-digital converter architecture, in accordance with one or more embodiments of the disclosure.

In the drawings, like reference symbols and numerals indicate the same or similar components. Like elements in the various figures are denoted by like reference symbols and numerals for consistency. Identical or similar items across different figures are indicated by the same reference numbers. Unless otherwise indicated, like elements and method steps are referred to with like reference numerals.

### DETAILED DESCRIPTION OF THE INVENTION

The following describes technical solutions in this specification with reference to the accompanying drawings. It should be recognized, however, that such description is not intended as a limitation on the scope of the present disclosure. Rather, the description also encompasses combinations and modifications to those exemplary aspects described herein. Exemplary embodiments are described in detail with reference to the accompanying drawings.

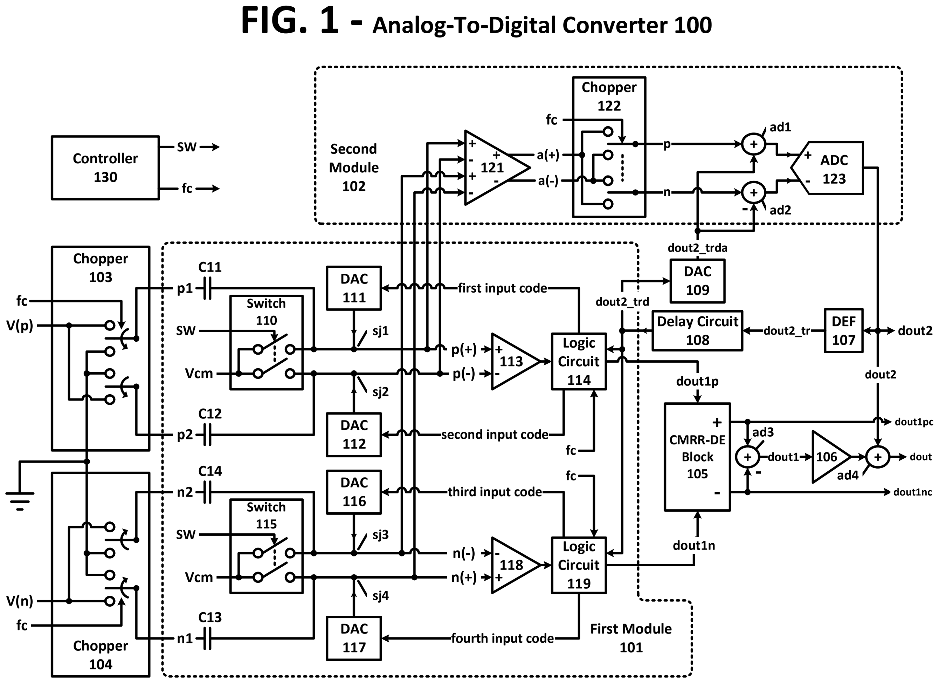

Turning now to FIG. 1, an analog-to-digital converter 100 is illustrated. The analog-to-digital converter 100 is an apparatus that may comprise several components that work together to perform analog-to-digital conversion. By way of illustration, the analog-to-digital converter 100 may include a first module 101, a second module 102, an input chopper 103, an input chopper 104, a common-mode rejection ratio digital enhancement (CMRR-DE) block 105, digital gain circuit 106, an output chopper 122, digital error feedback (DEF) circuit 107, a delay circuit 108, a digital-to-analog converter (DAC) 109 and a controller 130. In some implementations, the input choppers 103, 104 may each be a switch. In other implementations, the input choppers 103, 104 may each be a multiplexer. Those skilled in the art will appreciate there may be additional components in analog-to-digital converter 100.

The analog-to-digital converter 100 may employ a pipeline architecture. In analog-to-digital converters, kT/C noise may affect the overall resolution and accuracy of the conversion process. The first module 101 may operate in a continuous-time (CT) mode to eliminate the input sampling kT/C noise. kT/C noise introduced in the second module 102 is suppressed by amplifier 121 gain.

As used herein, the term "kT/C noise" refers to a fundamental noise source in electronic circuits, particularly in switched-capacitor systems and analog-to-digital converters. It is thermal noise associated with sampling onto a capacitor, where k is the Boltzmann constant, T is the absolute temperature, and C is the capacitance value. This noise sets a theoretical limit on the achievable signal-to-noise ratio in sampling systems and is inversely proportional to the capacitor size.

As used herein, the term "continuous-time input" refers to an input configuration of the analog-to-digital converter 100 where the input signals V(p), V(n) are directly coupled to the analog-to-digital converter 100 without being sampled and held at discrete time intervals. This configuration allows for high input impedance, reduced input-referred noise compared to traditional sampled data systems.

As used herein, the term "continuous-time mode" refers to an operational mode of the analog-to-digital converter 100 in which the input signals V(p), V(n) are processed continuously without discrete-time sampling at the first module 101. In the continuous-time mode, the analog-to-digital converter 100 may maintain a high input impedance and process the input signals V(p), V(n) in their continuous form, allowing for reduced noise and relaxed settling time requirements. The continuous-time mode enables the analog-to-digital converter 100 to process the input signals V(p), V(n) without introducing sampling artifacts or aliasing effects typically associated with discrete-time sampling.

In some implementations, the input signals V(p), V(n) may happen to be a differential analog signal. As a differential analog signal, the input signals V(p), V(n) may provide enhanced accuracy and noise rejection. The differential signal may consist of two complementary voltages, typically referred to as positive input (P) and negative input (N). Positive input signal V(p) and negative input signal V(n) may happen to be voltages equal in magnitude but opposite in polarity with respect to a common reference, such as ground. In the form of a differential signal, input signals V(p), V(n) may minimize common-mode noise and interference as the ADC digitizes V(p) and V(n) difference ideally detecting only their difference and rejecting any common-mode component.

First module 101 may include a first quantizer for the input signal V(p) and a second quantizer for the input signal V(n). The first quantizer may include input coupling capacitors C11 and C12, first DACs 111-112, first switch 110, first comparator 113 and first logic circuit 114. The second quantizer may include input coupling capacitors C13 and C14, second DACs 116-117, second switch 115, second comparator 118 and second logic circuit 119. The first quantizer may be an analog-to-digital converter, the second quantizer may be another analog-to-digital converter.

In some implementations, the first DACs 111-112 and the second DACs 116-117 may be a digital-to-analog converter (DAC). In other implementations, the first DACs 111-112 and the second DACs 116-117 may be a capacitive digital-to-analog converter (DAC), a resistor string DAC, a current-steering DAC, a charge-redistribution DAC, a thermometer-coded DAC and/or any other digital-to-analog converter. Those skilled in the art will appreciate there may be additional components in the first module 101.

Conventional AC coupling may employ a series capacitor to block DC components and pass only AC signals, resulting in a high-pass filter characteristic. However, this high-pass filter characteristic of conventional AC coupling may be problematic for applications where low-frequency components in a signal contain relevant information.

The first module 101 may perform capacitive input coupling technique. The capacitive input coupling technique may differ from conventional AC coupling. The first module 101 may include a feedback mechanism. The feedback mechanism may couple the input signals V(p), V(n) through input capacitors C11-C14 to high-impedance summing junctions sj1-sj4, respectively. Summing junctions sj1-sj4 may respectively connect to the first DACs 111-112 and the second DACs 116-117. The first DACs 111-112 and the second DACs 116-117 may provide a path for charge transfer at DC and low frequencies. The feedback mechanism may maintain a stable common-mode voltage at the summing junctions sj1-sj4 through periodic DAC refresh operations combined with input chopping. The input chopping may upconvert any introduced noise to frequencies outside the signal band of interest.

The capacitive input coupling technique may provide high input impedance and eliminate input sampling kT/C noise. The technique may process the full spectrum of the input signals V(p), V(n), including DC components in the input signals V(p), V(n). The capacitive input coupling technique may enable transmission of both AC and DC components of the input signals V(p), V(n) and preserve the DC and low-frequency content of the input signals V(p), V(n). The technique may process time-varying input signals V(P) and V(n) efficiently without rejecting the DC components in the input signals V(P) and V(n). The capacitive input coupling technique may maintain a stable common-mode voltage at the summing junctions sj1-sj4 without introducing undesirable filtering effects that may result from conventional AC coupling. The technique may be beneficial in applications where the input signals V(P) and V(n) may occupy extremely low frequencies that are close to DC. The capacitive input coupling technique may be advantageous for applications requiring measurement of slowly varying signals, where conventional AC coupling may lead to signal distortion or loss of low-frequency information.

To place the analog-to-digital converter 100 in a refresh mode, a controller 130 may cause the analog-to-digital converter 100 to perform a dynamic refresh. As used herein, the term "refresh mode" refers to an operational state of the analog-to-digital converter in which the capacitive arrays are temporarily disconnected from the signal path and reset to a known state.

As used herein, the term "dynamic refresh" refers to a technique for periodically resetting or refreshing the charge on capacitive elements in the analog-to-digital converter 100. Specifically, dynamic refresh involves temporarily disconnecting input and feedback capacitors from the signal path, resetting their charge to a known state, and then reconnecting them to the signal path. For example, the controller 130 may toggle a control signal SW in a manner that causes the first switch 110 to electrically connect the capacitive arrays formed by input capacitors C11-C12 and DACs 111-112 to a reset voltage Vcm while simultaneously controlling the chop signal fc in a manner that causes the input chopper 103 to electrically connect the first capacitor C11 and the second capacitor C12 to ground. The controller 130 may cause the analog-to-digital converter 100 to perform the dynamic refresh repeatedly at defined intervals.

During refresh mode, the capacitors C11-C12 are connected to ground, the DACs 111-112 and 116-117 connect to a digital reset code, and the summing junctions where C11 and DAC 111 connect and C12 and DAC 112 connect are connected to the reset voltage Vcm, typically a common-mode reset voltage Vcm, to compensate for charge leakage and maintain stable operation over extended periods. The refresh mode occurs periodically or with dithered timing and may be synchronized with the chopping clock to operate seamlessly without interrupting the conversion process. In high oversampling ratio implementations, first module conversion may be skipped during the refresh cycle. The refresh mode enables continuous long-term operation of the capacitively-coupled, continuous-time input analog-to-digital converter 100 by preventing drift and maintaining accuracy.

To place the analog-to-digital converter 100 in a chopping mode, a controller 130 may control a control signal SW in a manner that causes the first switch 110 to electrically disconnect the summing junctions sj1 and sj2 from the reset voltage Vcm then reconnects the input capacitors to the first module analog inputs and the DACs to their respective input codes.

As used herein, the term "chopping mode" refers to an operational state of the analog-to-digital converter 100 in which a) the input signals V(p), V(n) and b) the output signals both in the digital domain of the first module and the analog domain at amplifier 121 output are periodically switched or "chopped" between different signal paths. In this mode, the input choppers 103, 104 alternate the connections of capacitors C11-C14 between the input signals V(p), V(n) and ground at a predetermined chopping frequency. This periodic switching serves to modulate the input signals V(p), V(n). The output chopping at amplifier 121 output demodulates the input signals V(p) and V(n), undoing the action of the chopper switches, while modulating low-frequency noise to the chopping frequency where it can be easily filtered out in the digital domain. The chopping mode enables the analog-to-digital converter 100 to reduce the effects of low-frequency noise, offset errors, and 1/f noise, thereby improving the overall accuracy and performance of the conversion process. When first switch 110 is opened at the end of the refresh mode, reset kT/C noise is sampled on the capacitor arrays. This kT/C is upconverted to the chopping frequency in the chopping mode and is easily filtered in the digital domain. Hence, chopping enables the refresh mode to effectively reset the capacitive array with no noise penalty.

As used herein, the term "chopping frequency" refers to the rate at which the input choppers 103, 104 and the output chopper 122 alternate between signal paths during chopping mode operation. The chopping frequency is typically set significantly higher than the bandwidth of the input signals V(p), V(n), allowing for effective separation of the input signals V(p), V(n) from modulated noise and offset components in subsequent filtering stages.

Differential inputs to the first comparator 113 may include a non-inverting input and an inverting input. The first capacitor C11 may be disposed in the first quantizer between the input chopper 103 and the non-inverting input to the first comparator 113. Similarly, the second capacitor C12 may be positioned in the first quantizer between the input chopper 103 and the inverting input to the first comparator 113. This arrangement of capacitors C11 and C12 serves multiple purposes, including capacitive coupling of the continuous time input signal V(p) and maintaining a high input impedance for the ADC.

During the chopping mode, a controller 130 may oscillate the chop signal fc at the chopping rate in a manner that causes the input chopper 103 to toggle between electrically connecting the non-inverting input of the first comparator 113 to the input signal V(p) and ground through the first capacitor C11. Likewise, during the chopping mode, the controller 130 may oscillate the chop signal fc in a manner that causes the input chopper 103 to toggle between electrically connecting the inverting input of the first comparator 113 to the input signal V(p) and ground through the second capacitor C12. The input chopper 103 may electrically connect the first capacitor C11 to the input signal V(p) while simultaneously electrically connecting the second capacitor C12 to ground in some instances. In other instances, the input chopper 103 may electrically connect the first capacitor C11 to ground while simultaneously electrically connecting the second capacitor C12 to the input signal V(p).

The input chopper 103 may route either the input signal V(p) or ground to the first comparator 113 through the first capacitor C11 and the second capacitor C12. This routing configuration enables the first comparator 113 to switch between processing the input signal V(p) at one input terminal and establishing a reference level at the other input terminal.

While placing the analog-to-digital converter 100 in the refresh mode, the controller 130 may control a control signal SW in a manner that causes the second switch 115 to electrically connect summing junctions sj3, sj4 to the reset voltage Vcm while simultaneously controlling the chop signal fc in a manner that causes the input chopper 104 to electrically connect the third capacitor C13 and the fourth capacitor C14 to ground. In such instances, the controller 130 may control a control signal SW in a manner that causes the first switch 110 to electrically connect summing junctions sj1, sj2 to a reset voltage Vcm while simultaneously controlling the control signal SW in a manner that causes the second switch 115 to electrically connect summing junctions sj3, sj4 to the reset voltage Vcm.

Conversely, to place the analog-to-digital converter 100 in the chopping mode, the controller 130 may control the control signal SW in a manner that causes the second switch 115 to electrically disconnect summing junctions sj3 , sj4 from the reset voltage Vcm. In such instances, the controller 130 may control the control signal SW in a manner that causes the first switch 110 to electrically disconnect summing junctions sj1, sj2 from the reset voltage Vcm while simultaneously controlling the control signal SW in a manner that causes the second switch 115 to electrically disconnect summing junctions sj3, sj4 from the reset voltage Vcm.

Differential inputs to the second comparator 118 may include a non-inverting input and an inverting input. The third capacitor C13 may be disposed in the second quantizer between the input chopper 104 and the non-inverting input to the second comparator 118. Similarly, the fourth capacitor C14 may be positioned in the second quantizer between the input chopper 104 and the inverting input to the second comparator 118. This arrangement of capacitors C11 and C12 serves multiple purposes, including capacitive coupling of the continuous time input signal V(p) and maintaining a high input impedance for the ADC.

During the chopping mode, a controller 130 may oscillate the chop signal fc in a manner that causes the input chopper 104 to toggle between electrically connecting the non-inverting input of the second comparator 118 through the third capacitor C13 to the input signal V(n) while simultaneously electrically connecting the inverting input of the second comparator 118 through the fourth capacitor C14 to ground. Likewise, the controller 130 may oscillate the chop signal fc in a manner that causes the input chopper 104 to toggle between electrically connecting the non-inverting input of the second comparator 118 through the third capacitor C13 to ground while simultaneously electrically connecting the inverting input of the second comparator 118 through the fourth capacitor C14 to the input signal V(n).

The input chopper 104 may route either the input signal V(n) or ground to the second comparator 118 through the third capacitor C13 and the fourth capacitor C14. This routing configuration enables the second comparator 118 to switch between processing the input signal V(n) at one input terminal and establishing a reference level at the other input terminal.

The ability to switch between the input signal V(p) and ground also facilitates the periodic refresh of the first input capacitor C11 and DAC 111 in the first module 101. During the refresh mode, the input can be temporarily disconnected by switching to ground, allowing the capacitive array formed by the input capacitor and the DAC to reset its charge without interference from the input signal. This periodic refresh, combined with the input chopping, helps maintain a stable common-mode voltage at the first comparator 113 input without introducing low-frequency noise. In some implementations, the refresh mode may be triggered adaptively based on detected drift or error conditions, rather than at fixed intervals.

First comparator 113 may receive intermediate signal p(+) at the non-inverting input and intermediate signal p(-) at the inverting input and may compare intermediate signal p(+) against intermediate signal p(-). This comparison may produce a first bistable signal with two distinct states: a high state where intermediate signal p(+) may exceed intermediate signal p(-), and a low state where intermediate signal p(+) may be less than or equal to intermediate signal p(-). In some implementations, the first bistable signal may comprise a bitstream. A data width of the bitstream may comprise a single bit. The logic level for the bit may correspond to either the high state or the low state.

The first logic circuit 114 may receive and process the first bistable signal from first comparator 113. While processing the first bistable signal, the first logic circuit 114 may implement successive approximation register (SAR), Delta-Modulation (DM), and dynamic element matching (DEM) algorithms. The first logic circuit 114 may manage a binary search process and may refine the digital input codes iteratively. The binary search process involves systematically using the bitstream from first comparator 113, halving the search interval with each iteration, to efficiently determine the digital representation of the input signal V(p). The binary search process may be utilized during the initial conversion phase to quickly approximate the input signal V(p) before transitioning to Delta-Modulation for tracking signal changes.

The first logic circuit 114 may operate in SAR mode initially to determine an approximate digital representation of the input signal V(p). After initial SAR conversion, the first logic circuit 114 may switch to DM mode to track changes in the input signal V(p) while reducing power consumption. The DEM functionality may dynamically reorder capacitive digital-to-analog converter element usage to average out mismatch errors and enhance linearity. By combining these techniques, the first logic circuit 114 may enable accurate conversion while optimizing power efficiency and performance.

The first logic circuit 114 may process the first bistable signal and control the DACS 111-112 accordingly. The first logic circuit 114 may perform binary search initially, switch to delta-modulation operation where the DAC code may increment or decrement by one code based on the comparator output, and perform dynamic element matching for the DACs 111-112, dynamically shuffling DAC element selection to shape mismatch error and push the error to higher frequencies outside the signal band of interest.

The first logic circuit 114 may process the first bistable signal as follows: Initially, the first logic circuit 114 may use the comparator output to perform binary search when the ADC powers on or receives an input signal for the first time. Afterwards, the controllers may switch to "Delta-Modulation" mode. In this mode, the first logic circuit 114 may increment or decrement the DAC code by 1 based on the comparator output. The Delta-Modulation phase may trigger the comparator multiple times to resolve multiple bits and update the DACS 111-112 accordingly. The implementation may include programmability for the number of bits resolved in the Delta-Modulation phase.

SAR logic may refer to digital control circuitry implementing the successive approximation register algorithm in an analog-to-digital converter. This logic may control the binary search process, comparing input signals against reference voltages and refining the digital input codes iteratively. SAR logic may be used in the initial conversion phase of the first module 101 to determine an approximate digital representation of the input signal V(p), V(n).

DM logic may refer to digital control circuitry implementing the Delta-Modulation algorithm in an analog-to-digital converter. This logic may increment or decrement the digital input codes based on whether the input signal may be higher or lower than the previous estimate. DM logic may be employed after initial SAR conversion to track input signal changes with reduced power consumption.

DEM logic may refer to digital control circuitry implementing dynamic element matching techniques in an analog-to-digital converter. This logic may dynamically reorder capacitive digital-to-analog converter (DAC) element usage to average out mismatch errors and improve linearity. DEM logic may be used with SAR and DM logic to enhance overall ADC accuracy and performance.

Illustrated in FIG. 1 are the first DAC 111 and the second DAC 112, each being a capacitive digital-to-analog converter. As used herein, the term "capacitive digital-to-analog converter" or "DAC" may refer to a type of digital-to-analog converter that uses a network of either binary-weighted, thermometer coded, or segmented capacitive arrays to convert digital input codes into analog output voltages. Referred to herein, the term "digital input code" refers to a binary representation of data that is input to a capacitive digital-to-analog converter (DAC) within the analog-to-digital converter architecture. The digital input code comprises a series of bits, typically corresponding to the number of capacitors in the DAC array, where each bit controls the charging or discharging of a specific capacitor in the DAC array.

The first logic circuit 114 may implement the successive approximation register (SAR), the Delta-Modulation (DM), and the dynamic element matching (DEM) algorithms to produce digital input codes in a first input code and a second input code. From the first logic circuit 114, the first DAC 111 may receive the first input code while the second DAC 112 may receive the second input code. The first and second input codes may or may not be complementary, with the first input code controlling the first DAC 111 and the second input code controlling the second DAC 112. This differential operation may help maintain balance in the DAC operation and may contribute to improved interference rejection. The first logic circuit 114 may adjust these digital input codes dynamically during the conversion process, potentially updating the digital input codes after each comparison or iteration of the conversion algorithm. By providing the digital input codes to the DACs 111-112, the first logic circuit 114 may enable precise adjustment of the DAC output, potentially improving the overall accuracy and linearity of the analog-to-digital converter 100.

The first DAC 111 and the second DAC 112 may each comprise an array of capacitors, each capacitor in the array having a value that is a binary multiple of a unit capacitance. As used herein, the term "unit capacitance" refers to the smallest capacitance value used in the DAC array, typically representing the least significant bit (LSB) of the digital input code. Binary weighting of the capacitors allows for efficient implementation of the digital-to-analog conversion process. The digital input codes, which controls the charging and discharging of specific capacitors in the array of capacitors, are binary representations of data generated by the first logic circuit 114. The first DAC 111 and the second DAC 112 may each use digital input codes to selectively charge or discharge the capacitors within the first and second DACs 111-112 based on the results of the SAR, DM, and DEM algorithms implemented in the first logic circuit 114.

The first DAC 111 may operate by selectively charging or discharging the capacitors based on the first input code, resulting in a redistribution of electrical charges between capacitors in the capacitor array of the first DAC 111. By selective charging or discharging the capacitors, the first DAC 111 may produce a first analog output voltage that is proportional to the first input code.

Summing junction sj1 may wire the output of capacitive array composed of input capacitor C11 and the first DAC 111 directly to the non-inverting input of the first comparator 113 and a first non-inverting input of the amplifier 121 as illustrated in the example of FIG. 1. For instance, summing junction sj1 may include one or more wires or conductive traces that link together various components of the analog-to-digital converter 100. Summing junction sj1 may combine DAC 111 output with the input signal V(p) that has been capacitively-coupled through capacitor C11. The resulting intermediate signal p(+) may represent the weighted sum of the input signal V(p) and the first analog output voltage .

The second DAC 112 may operate by selectively charging or discharging the capacitors based on the second input code, resulting in a redistribution of electrical charges between capacitors in the capacitor array of the second DAC 112. By selective charging or discharging the capacitors, the second DAC 112 may produce a second analog output voltage that is proportional to the second input code.

Summing junction sj2 may wire an output from the capacitive array formed by input capacitor C12 and second DAC 112 directly to the inverting input of the first comparator 113 and a first inverting input of the amplifier 121 as illustrated in the example of FIG. 1. For instance, summing junction sj2 may include one or more wires or conductive traces that link together various components of the analog-to-digital converter 100. Summing junction sj2 may combine the second analog output voltage with the input signal V(p) that has been capacitively-coupled through capacitor C12. The resulting intermediate signal p(-) may represent the weighted sum of the input signal V(p) and the second analog output voltage.

The first DAC 111 and second DAC 112 may work together to implement a first differential arrangement where signals p(+) and p(-) represent first quantizer residue voltage. Both first comparator 113 and amplifier 121 operate on the difference of p(+) and p(-). As used herein, the term "common-mode rejection" refers to the ability of the differential arrangement to suppress noise and interference that affects both the positive and negative sides of the signal equally, thereby improving the signal-to-noise ratio and accuracy of the analog-to-digital conversion process. This first differential arrangement may help improve the common-mode rejection and the overall performance of the analog-to-digital converter 100.

Second comparator 118 may receive intermediate signal n(+) at the non-inverting input and intermediate signal n(-) at the inverting input and may compare intermediate signal n(+) against intermediate signal n(-). This comparison may produce a second bistable signal with two distinct states: a high state where intermediate signal n(+) may exceed intermediate signal n(-), and a low state where intermediate signal n(+) may be less than or equal to intermediate signal n(-). In some implementations, the second bistable signal may comprise a bitstream. A data width of the bitstream may comprise a single bit. The logic level for the bit may correspond to either the high state or the low state.

The second logic circuit 119 may receive and process the second bistable signal from second comparator 118. While processing the second bistable signal, the second logic circuit 119 may implement successive approximation register (SAR), Delta-Modulation (DM), and dynamic element matching (DEM) algorithms. The second logic circuit 119 may manage a binary search process and may refine the digital input codes iteratively. The binary search process involves systematically using the bitstream from second comparator 118, halving the search interval with each iteration, to efficiently determine the digital representation of the input signal V(n). The binary search process may be utilized during the initial conversion phase to quickly approximate the input signal V(n) before transitioning to Delta-Modulation for tracking signal changes.

The second logic circuit 119 may operate in SAR mode initially to determine an approximate digital representation of the input signal V(n). After initial SAR conversion, the second logic circuit 119 may switch to DM mode to track changes in the input signal V(n) while reducing power consumption. The DEM functionality may dynamically reorder capacitive digital-to-analog converter element usage to average out mismatch errors and enhance linearity. By combining these techniques, the second logic circuit 119 may enable accurate conversion while optimizing power efficiency and performance.

The second logic circuit 119 may process the second bistable signal and control the DACs 116-117 accordingly. The second logic circuit 119 may perform binary search initially, switch to delta-modulation operation where the DAC code may increment or decrement by one code based on the comparator output, and perform dynamic element matching for the DACs 116-117, dynamically shuffling DAC element selection to shape mismatch error and push the error to higher frequencies outside the signal band of interest.

The second logic circuit 119 may process the second bistable signal as follows: Initially, the second logic circuit 119 may use the comparator output to perform binary search when the ADC powers on or receives an input signal for the third time. Afterwards, the controllers may switch to "Delta-Modulation" mode. In this mode, the second logic circuit 119 may increment or decrement the DAC code by 1 based on the comparator output. The Delta-Modulation phase may trigger the comparator multiple times to resolve multiple bits and update the DACS 116-117 accordingly. The implementation may include programmability for the number of bits resolved in the Delta-Modulation phase.

SAR logic may refer to digital control circuitry implementing the successive approximation register algorithm in an analog-to-digital converter. This logic may control the binary search process, comparing input signals against reference voltages and refining the digital input codes iteratively. SAR logic may be used in the initial conversion phase of the first module quantizers to determine an approximate digital representation of the input signal.

DM logic may refer to digital control circuitry implementing the Delta-Modulation algorithm in an analog-to-digital converter. This logic may increment or decrement the digital input codes based on whether the input signal may be higher or lower than the previous estimate. DM logic may be employed after initial SAR conversion to track input signal changes with reduced power consumption.

DEM logic may refer to digital control circuitry implementing dynamic element matching techniques in an analog-to-digital converter. This logic may dynamically reorder capacitive digital-to-analog converter (DAC) element usage to average out mismatch errors and improve linearity. DEM logic may be used with SAR and DM logic to enhance overall ADC accuracy and performance.

Illustrated in FIG. 1 are the third DAC 116 and the fourth DAC 117, each being a capacitive digital-to-analog converter. The digital input code comprises a series of bits, typically corresponding to the number of capacitors in the DAC array, where each bit controls the charging or discharging of a specific capacitor in the DAC array.

The second logic circuit 119 may implement the successive approximation register (SAR), the Delta-Modulation (DM), and the dynamic element matching (DEM) algorithms to produce digital input codes in a third input code and a fourth input code. From the second logic circuit 119, the third DAC 116 may receive the third input code while the fourth DAC 117 may receive the fourth input code. The third and fourth input codes may or may not be complementary, with the third input code controlling the third DAC 116 and the fourth input code controlling the fourth DAC 117. This differential control scheme may help maintain balance in the DAC operation and may contribute to improved common-mode rejection. The second logic circuit 119 may adjust these digital input codes dynamically during the conversion process, potentially updating the digital input codes after each comparison or iteration of the conversion algorithm. By providing the digital input codes to the DACs 116-117, the second logic circuit 119 may enable precise adjustment of the reference voltages used in the analog-to-digital conversion process, potentially improving the overall accuracy and linearity of the analog-to-digital converter 100.

The third DAC 116 and the fourth DAC 117 may each comprise an array of capacitors, each capacitor in the array having a value that is a binary multiple of a unit capacitance. The digital input codes, which controls the charging and discharging of specific capacitors in the array of capacitors, are binary representations of data generated by the second logic circuit 119. The third DAC 116 and the fourth DAC 117 may each use digital input codes to selectively charge or discharge the capacitors within the third and fourth DACs 116-117 based on the results of the SAR, DM, and DEM algorithms implemented in the second logic circuit 119.

The third DAC 116 may operate by selectively charging or discharging the capacitors based on the third input code, resulting in a redistribution of electrical charges between capacitors in the capacitor array of the third DAC 116. By selective charging or discharging the capacitors, the third DAC 116 may produce a third analog output voltage that is proportional to the third input code.

Summing junction sj3 may wire an output from the capacitive array formed by input capacitor C13 and third DAC 116 directly to the non-inverting input of the second comparator 118 and a second inverting input of the amplifier 121 as illustrated in the example of FIG. 1. For instance, summing junction sj3 may include one or more wires or conductive traces that link together various components of the analog-to-digital converter 100. Summing junction sj3 may combine the third analog output voltage with the input signal V(n) that has been capacitively-coupled through capacitor C13. The resulting intermediate signal n(+) may represent the weighted sum of the input signal V(n) and the third analog output voltage.

The fourth DAC 117 may operate by selectively charging or discharging the capacitors based on the fourth input code, resulting in a redistribution of electrical charges between capacitors in the capacitor array of the fourth DAC 117. By selective charging or discharging the capacitors, the fourth DAC 117 may produce a fourth analog output voltage that is proportional to the fourth input code.

Summing junction sj4 may wire an output from the capacitive array formed by input capacitor C14 and fourth DAC 117 directly to the inverting input of the second comparator 118 and a second non-inverting input of the amplifier 121 as illustrated in the example of FIG. 1. For instance, summing junction sj4 may include one or more wires or conductive traces that link together various components of the analog-to-digital converter 100. Summing junction sj4 may combine the fourth analog output voltage with the input signal V(n) that has been capacitively-coupled through capacitor C14. The resulting intermediate signal n(-) may represent the weighted sum of the input signal V(n) and the fourth analog output voltage.

The third DAC 116 and fourth DAC 117 may work together to implement a second differential arrangement where signals n(+) and n(-) represent the second quantizer residue voltage. Both second comparator 118 and amplifier 121 operate on the difference of n(+) and n(-).

The second module 102 may include an amplifier 121, an output chopper 122 and an analog-to-digital (ADC) circuit 123. The second module 102 may contain additional components. In some configurations, the output chopper 122 may be a switch. In other configurations, the output chopper 122 may be a multiplexer.

The amplifier 121 may receive multiple pairs of differential signals and output a single differential pair of signals. As depicted in FIG. 1, first differential inputs of the amplifier 121 are wired directly to the differential inputs of the first comparator 113 so that the first differential inputs of the amplifier 121 may receive a first intermediate signal pair p(+), p(-).

As used herein, the term "wired directly" refers to an electrical connection between two components or nodes that does not include any intervening active component or signal processing element. A direct wired connection may comprise conductive traces on a circuit board, wire bonds, or other conductive pathways that provide a low-impedance electrical path between the connected points. The direct wired connection may allow signals to propagate between the components or nodes without intermediate amplification, filtering, or other signal conditioning.

Also depicted in FIG. 1, second differential inputs of the amplifier 121 are wired directly to the differential inputs of the second comparator 118 so that the second differential inputs of the amplifier 121 may receive a second intermediate signal pair n(+), n(-). For instance, a first non-inverting input of amplifier 121 may receive intermediate signal p(+) from the first quantizer while first inverting input of amplifier 121 may receive intermediate signal p(-) from the first quantizer. A second non-inverting input of amplifier 121 may receive intermediate signal n(-) and a second inverting input of amplifier 121 may receive intermediate signal n(+). The intermediate signal pair p(+), p(-) and the second intermediate signal pair n(+), n(-) are each differentially processed in the example of FIG. 1. The term "differential processing" may refer to processing the difference of a pair of electrical signals with improved noise immunity compared to single-ended processing.

In amplifier 121, multiple intermediate signal pairs may connect to a common pair of output nodes. The output node configuration may refer to the arrangement of electrical nodes in the amplifier 121 where multiple intermediate signal pairs share common output nodes. This architecture may enable the amplifier 121 to process several input signals while producing a single differential output. This approach may allow the amplifier 121 to process the sum or difference of multiple input signals simultaneously while producing a unified output.

The amplifier 121 may provide amplified signals to the output chopper 122. This amplification relaxes the noise requirements for ADC circuit 123. The output chopper 122 may connect to the interstage amplifier 121. The output chopper 122 may be implemented as a double-pole, double-throw (DPDT) switch or an equivalent circuit configuration. The output chopper 122 may perform a dechopping process. As used herein, the term "dechopping process" is a process that reverses the effects of input chopping. The dechopping process may demodulate the amplified differential signals, potentially shifting the amplified differential signals back to their original frequency band. The output chopper 122 chops low-frequency noise and DC offsets that are injected between the first and second chopping switches 110 and 115 and the output chopper 122 shifting them to the chopping frequency, which is much higher than the signal band of interest, during the chopping process. This effectively separates the signal and the modulated low-frequency noise and offset in the frequency spectrum enabling low-frequency noise and offset filtering in the digital domain. In addition to the chopping function, the output chopper 122 may sample the amplified input signals at specific time intervals. This would convert the continuous-time intermediate signals into discrete-time samples for processing by the ADC circuit 123.

The output chopper 122 may operate in conjunction with the input choppers 103-104 to implement a complete chopping and sampling cycle, which may be used to reduce low-frequency noise, offset errors, and noise in the analog-to-digital conversion process. The output chopper 122 may be controlled by a clock signal fc that may synchronize output chopper 122 with the switches 103-104 to ensure proper signal reconstruction. Output chopper 122 may then feed sampled signals to the ADC circuit 123 in the form of the positive and negative differential signals.

The ADC circuit 123 may receive the positive and negative differential signals ("the differential signal pair") from the output chopper 122 and prepare the differential signal pair for the subsequent conversion stages. The ADC circuit 123 may be a differential analog-to-digital converter. A differential analog-to-digital converter may be an analog-to-digital converter that accepts a pair of differential signals and converts the pair into a digital representation of differential signals. The term "digital representation of differential signals" may refer to a discrete numerical encoding that consists of a series of binary values in the form of a binary code (dout2). The binary code (dout2) may approximate the amplitude and polarity of the differential signal pair at specific sampling points. This approach may allow for improved noise immunity and dynamic range compared to single-ended digital representations, as common-mode noise affecting both input lines equally may be effectively cancelled out in the resulting digital output.

The ADC circuit 123 may comprise a discrete-time noise-shaped successive approximation register (DT NS-SAR). A discrete-time noise-shaped successive approximation register or DT NS-SAR may refer to an analog-to-digital converter architecture that combines successive approximation and noise shaping in a discrete-time implementation. This architecture may employ a successive approximation register (SAR) as the core conversion mechanism, but may incorporate additional feedback and noise shaping techniques to enhance performance, particularly for noise reduction and effective resolution. In a DT NS-SAR, the input signal may be sampled at discrete time intervals, and noise shaping may be applied to the quantization error, shifting the signal to higher frequencies outside the signal band of interest. Noise shaping may improve the signal-to-noise ratio (SNR) and effective number of bits (ENOB) compared to traditional SAR ADCs, especially for oversampling applications. The discrete-time nature of this architecture may make it suitable for integration with digital signal processing systems and may allow for control over the noise shaping characteristics.

The DEF circuit 107 may receive the binary code (dout2) from the ADC circuit 123. The DEF circuit 107 may be a specialized digital circuit that may perform truncation of the binary code while simultaneously shaping the spectral content of the resulting truncation error. The term "truncation" may refer to the process of reducing the bit width or precision of the binary code (dout2) by removing least significant bits. The DEF circuit 107 may truncate the binary code (dout2), effectively reducing the bit width of the binary code (dout2). The DEF circuit 107 may reduce the bit width while shifting the introduced truncation error to frequencies outside the signal band of interest.

The DEF circuit 107 may employ digital filters and noise-shaping algorithms to achieve the desired spectral shaping of the truncation error. The term "spectral shaping" may refer to a technique employed in the digital error feedback (DEF) circuit of the analog-to-digital converter architecture to manipulate the frequency distribution of quantization errors or truncation noise. This technique may involve selectively altering the spectral characteristics of the truncated dout2 (dout2_tr), typically by redistributing its energy across different frequency bands. Spectral shaping may be applied to shift the truncation error resulting from bit-width reduction to frequencies outside the signal band of interest. This technique may allow for the preservation of signal integrity within the desired frequency range while minimizing the impact of quantization noise on the overall signal-to-noise ratio (SNR) of the analog-to-digital conversion process.

Gain errors may represent deviations from ideal gain values in amplifier or conversion stages of analog-to-digital converter 100. These errors may potentially cause non-linearity and reduce resolution in digital signal representation. Gain errors may present challenges in the design and may introduce inaccuracies affecting digital output fidelity of analog-to-digital converter 100. Managing gain errors may improve conversion process linearity and accuracy.

The term "error shaping" may refer to a process that actively modifies the characteristics of truncation errors within the DEF circuit 107, gain error within analog-to-digital converter 100, or quantization error within ADC circuit 123. In this analog-to-digital converter architecture, error shaping may involve the deliberate manipulation of the spectral distribution of truncation errors resulting from bit-width reduction. The primary goal of error shaping may be to push the majority of the error energy to frequency ranges outside the band of interest, thereby minimizing its impact on the desired signal. This technique may be useful for maintaining the overall performance and accuracy of the analog-to-digital converter, particularly in applications requiring high precision and low noise in specific frequency bands.

The analog-to-digital converter 100 may employ gain error-shaping techniques to enhance performance and accuracy. Gain error-shaping may mitigate the effects of gain errors that may occur during the conversion process. Gain error shaping (GES) loops may comprise several elements within analog-to-digital converter 100, including the DEF circuit 107, delay circuit 108, digital gain scaling factor, and adders at various conversion stages. For instance, a gain error-shaping loop may comprise the DEF circuit 107, delay circuit 108, first logic circuit 114, DACs 111-112 and second module 102. Another gain error-shaping loop may comprise the DEF circuit 107, delay circuit 108, second logic circuit 119, DACs 116-117 and second module 102.

Analog-to-digital converter 100 may employ gain error-shaping techniques. The analog-to-digital converter 100 may include a feedback loop to spectrally shape or redistribute gain errors outside the signal band of interest. Analog-to-digital converter 100 may concentrate gain error energy in non-interfering frequency ranges. As the feedback loop continuously operates, this may allow analog-to-digital converter 100 to adapt to changing conditions. By pushing gain errors outside the band of interest, analog-to-digital converter 100 may achieve higher effective number of bits (ENOB) within the desired signal bandwidth. The digital nature of the gain error shaping loop may allow integration with other digital signal processing functions.

Gain error-shaping may refer to a technique mitigating gain error effects. The gain error-shaping process may adjust gain to redistribute errors outside the signal band of interest. This process may utilize digital feedback to shape the gain error. Gain error-shaping may improve accuracy and linearity. The technique may benefit the multi-stage or pipeline architecture. Gain error-shaping may noise-shape gain error. This shaping may contribute to the ability of analog-to-digital converter 100 to produce digital representations of analog signals.

The analog-to-digital converter 100 may include several gain error shaping loops. The gain error shaping technique may be evident in the ability of analog-to-digital converter 100 to process various signals in parallel while maintaining accuracy. For instance, multiple gain error shaping loops are paths in analog-to-digital converter 100. The gain error shaping loops may operate in parallel during ADC conversion of the input signals V(p), V(n).

DEF circuit 107 may exist as a component in both the gain error shaping loops. By way of illustration, DEF circuit 107 may receive the binary signal (dout2) from the ADC circuit 123. DEF circuit 107 may perform signal truncation on the binary signal (dout2) and push a truncation error to frequencies outside the signal band of the input signals V(p), V(n) to address truncation errors through noise-shaping in such instances. Under such conditions, the DEF circuit 107 may scale down the binary signal (dout2) by a digital gain factor in the form of a truncated signal (dout2_tr).

A delayed signal (dout2_trd) from delay circuit 108 may help maintain stability and synchronization in the gain error-shaping loops. Existing as a component in the gain error shaping loops, the delay circuit 108 may introduce a controlled time delay in the truncated signal (dout2_tr) that synchronizes signals with the gain error shaping loops. For instance, the delay circuit 108 may set the time delay for the truncated signal (dout2_tr) to one ADC conversion cycle. In some implementations, the delay circuit 108 may extend the time delay to two or more ADC conversion cycles for increased flexibility. While the time delay may generally remain fixed during the chopping mode, some designs may incorporate programmability.

The DAC 109 may convert the delayed truncated digital signal (dout2_trd) from the delay circuit 107 into an analog delayed truncated signal (dout2_trda) and output the analog delayed truncated signal (dout2_trda) to adders ad1, ad2. The DAC 109 can be a dedicated DAC or a repurposed ADC 123 DAC. Adders ad1 and ad2 may serve as components in the gain error shaping loop. Physical implementations of the adders ad1 and ad2 may vary and can be as simple as wiring connecting the DAC 109 and the output chopper 122 to the ADC circuit 123. For instance, adders ad1 and ad2 may combine the analog delayed truncated signal (dout2_trda) with input signals and provide the combination of the analog delayed truncated signal (dout2_trda) with input signals to the non-inverting (+) and inverting (-) inputs of the ADC circuit 123, as illustrated in the example of FIG. 1. Adders ad1, ad2 may add the analog delayed truncated signal (dout2_trda) with the amplified residue signal (p), (n) from the output chopper 122.

The delay circuit 108 may convert the digital truncated signal (dout2_tr) from the DEF circuit 107 into a digital delayed truncated signal (dout2_trd) and output the digital delayed truncated signal (dout2_trd) to the first logic circuit 114 and the second logic circuit 119. The first and second logic circuits 114 and 119 may process the digital delayed truncated signal (dout2_trd) to generate the first and second input codes, respectively.

The CMRR digital enhancement circuit (CMRR-DE) block 105 may receive a digital signal (dout1p) and a digital signal (dout1n), which are the digital outputs of first module 101 first and second quantizers. Digital signals (doutlp) and (dout1n) contain both a desired differential signal and an undesired common-mode signal. CMRR-DE block 105 corrects for the gain mismatch between the first and second quantizers by applying different gain to signals (doutlp) and (dout1n). After this gain correction, the common-mode signal has equal amplitude in both signals (dout1pc) and (dout1nc) and hence is rejected at the output of CMRR-DE block 105 when digital signals (dout1pc) and (dout1nc) are subtracted using digital adder ad3. CMRR measures how well an analog-to-digital converter 100 can reject noise that are common to both the input signal V(p) and input signal V(n), while amplifying the difference between signal (dout1pc) and signal (dout1nc). Common mode rejection may be expressed in decibels (dB), which may represent the ratio of the differential mode gain to the common-mode gain. A higher CMRR may indicate improved rejection of common-mode interference and enhanced accuracy in measuring the desired differential signal. The CMRR-DE block 105 processing may suppress a common mode component of the differential pair. The common mode component may be the average of input signal V(p) and input signal V(n) and the component that is identical in both the input signal V(p) and input signal V(n).

CMRR digital enhancement may be a technique implemented in the digital domain to improve the common-mode rejection ratio of the analog-to-digital converter 100. This technique may involve digital processing of the digitized signals dout1p and dout1n from the first and second logic circuits 114, 119 to suppress common-mode interference. Digital CMRR enhancement may include algorithms for detecting and cancelling common-mode components in the digitized signals, adaptive filtering to track and remove time-varying common-mode interference, and digital calibration techniques to compensate for mismatches in the analog components that can degrade CMRR performance. The CMRR-DE block 105 may output a pair of signals (dout1pc), (dout1nc).

Digital adder ad3 may subtract CMRR-DE digital outputs (dout1pc), (dout1nc) to reject the common-mode signal and generate first module 101 corrected output signal (dout1) that represents the coarse quantization of input signals V(p), V(n). To align the coarse and fine quantization, digital gain circuit 106 may be configured to scale signal (dout1) by a gain factor G before digital adder ad4 adds the scaled signal (dout1) to the binary code (dout2) to construct the final ADC output (dout).

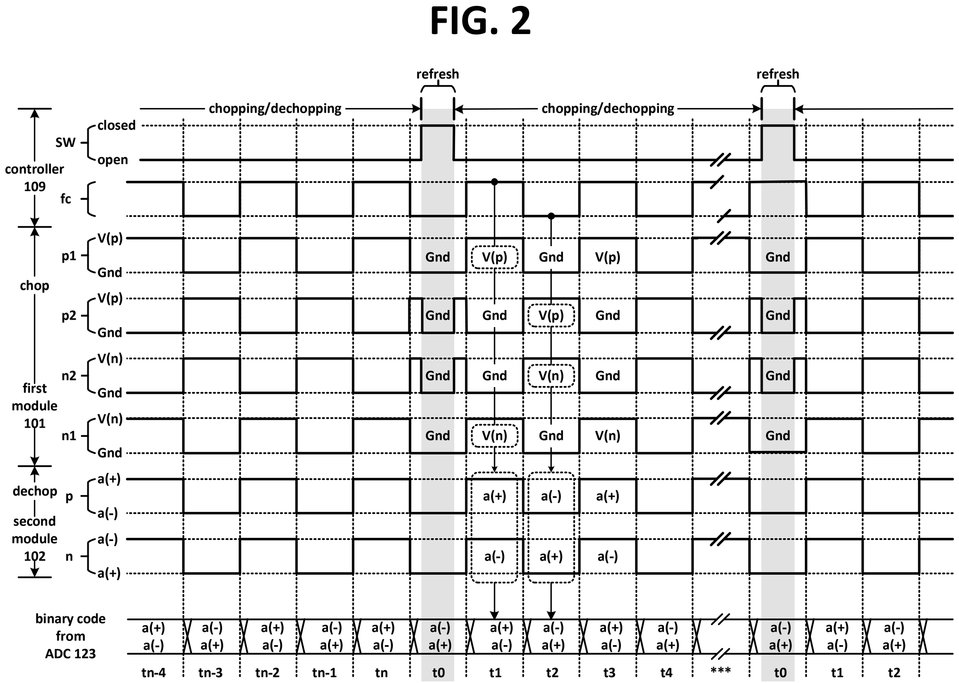

Turning now to FIG. 2, timing diagram is illustrated. Depicted in FIG. 2 is an exemplary timing for the analog-to-digital converter 100. Illustrated in FIG. 2 are the control signal SW, the chop signal fc, input signals p1-p2, input signals n1-n2, intermediate signals a(+) and a(-), and the binary code (dout2).

The controller 130 may repetitively alternate the overall operation of the analog-to-digital converter 100 between a refresh mode and a chopping mode. The controller 130 may repetitively alternate the control signal SW between an open state to place the first module 101 in the chopping mode and a closed state to place the first module 101 in the refresh mode. The time duration of the chopping mode is longer than the time duration of the refresh mode.

To place the first module 101 in the refresh mode during time period (t0), the controller 130 may set control signal SW to the closed state so that the first switch 110 may electrically connect input capacitors C11, C12 and DACs 111,112 to the reset voltage Vcm and so that the second switch 115 may electrically connect input capacitors C13, C14 and DACs 116,117 to the reset voltage Vcm. Simultaneously with setting the control signal SW to the closed state, the controller 130 may control the chop signal fc in a manner that causes the input chopper 103 to electrically connect the input signals p1-p2 to ground and in a manner that causes the input chopper 104 to electrically connect the input signals n1-n2 to ground. The duration of the refresh mode is typically much smaller than an ADC conversion cycle.

To place the first module 101 in the chopping mode, the controller 130 may set control signal SW to the open state during time periods other than time period (t0) so that the first switch 110 may electrically disconnect input capacitors C11, C12 and DACs 111,112 from the reset voltage Vcm and so that the second switch 115 may electrically disconnect capacitors C13, C14 and DACs 116,117 from the reset voltage Vcm. Simultaneously with setting the control signal SW to the open state, the controller 130 may control the chop signal fc in a manner that causes the input chopper 103 to toggle the input signals p1-p2 between the input signals V(p) and ground as illustrated in FIG. 2. Also simultaneously with setting the control signal SW to the open state, the controller 130 may control the chop signal fc in a manner that causes the input chopper 104 to toggle the input signals n1-n2 between the input signals V(n) and ground.

Illustrated in FIG. 2 is an example, during time period (t1), where the chop signal fc may cause the input chopper 103 to electrically connect the input signal V(p) to the first capacitor C11 in the form of a first input signal p1 while simultaneously grounding the second capacitor C12 (second input signal p2 = Gnd). Also during time period (t1), the chop signal fc may cause the input chopper 104 to ground the fourth capacitor C14 (fourth input signal n2 = Gnd) while simultaneously electrically connecting the input signal V(n) to the third capacitor C13 in the form of a third input signal n1.

The differential amplifier 121 may output intermediate signals a(+) and a(-) during time period (t1), where the output chopper 122 may route intermediate signal a(+) to the adder ad1 and intermediate signal a(-) to adder ad2. For instance, adder ad1 may include one or more wires or conductive traces that link together various components of the analog-to-digital converter 100. The differential amplifier 121 may also output intermediate a(-) during time period (t1), where the output chopper 122 may route intermediate signal a(-) to the adder ad2. For instance, adder ad2 may include one or more wires or conductive traces that link together various components of the analog-to-digital converter 100. During residue amplification by amplifier 121, the adder ad1 may combine the intermediate signal a(+) with the analog delayed truncated signal (dout2_trda) while the adder ad2 may combine the intermediate signal a(-) with the analog delayed truncated signal (dout2_trda). The ADC circuit 123 may process the difference of intermediate signals a(+) and a(-) to output a binary code (dout2).

The differential amplifier 121 may output intermediate signals a(+) and a(-) during time period (t2), where the output chopper 122 may route intermediate signal a(-) to the adder ad1 and intermediate a(+) to adder ad2. During residue amplification by amplifier 121, the adder ad1 may combine the intermediate signal a(-) with the analog delayed truncated signal (dout2_trda) while the adder ad2 may combine the intermediate signal a(+) with the analog delayed truncated signal (dout2_trda). The ADC circuit 123 may process the difference of intermediate signals a(-) and a(+) to output a binary code (dout2).

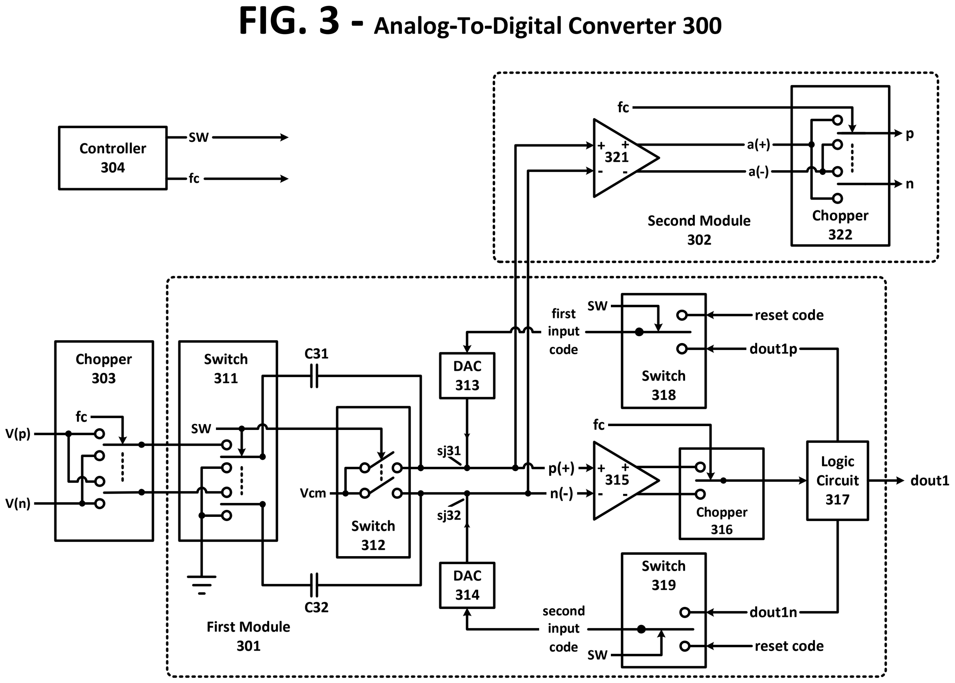

FIG. 3 may illustrate an analog-to-digital converter 300. The analog-to-digital converter 300 may comprise a first module 301, a second module 302, an input chopper 303 and a controller 304. The analog-to-digital converter 300 may include several components that work together to perform analog-to-digital conversion. The first module 301 may include a quantizer that may comprise a first refresh switch 311, a second refresh switch 312, capacitors C31-C32, a first DAC 313, a second DAC 314, a comparator 315, a digital chopper 316, a logic circuit 317, a first logic switch 318 and a second logic switch 319. In some implementations, the input chopper 303 may be a switch. In other implementations, the input chopper 303 may be a multiplexer. In some configurations, the digital chopper 316 may be a switch. In other configurations, the digital chopper 316 may be a multiplexer.

Differential inputs to the comparator 315 may include a non-inverting input and an inverting input. The first capacitor C31 may be disposed in the quantizer between the first refresh switch 311 and the non-inverting input to the comparator 315. The second capacitor C32 may be positioned in the quantizer between the first refresh switch 311 and the inverting input to the comparator 315. This arrangement of capacitors C31 and C32 may serve multiple purposes, including capacitive coupling of the input signals V(p) and V(n) and maintaining a high input impedance for the ADC.

To place the analog-to-digital converter 300 in the refresh mode, the controller 304 may toggle a control signal SW in a manner that causes the first refresh switch 311 to electrically connect the first capacitor C31 and the second capacitor C32 to ground while simultaneously causing a) the second refresh switch 312 to electrically connect C31, C32 and DACs 313, 314 to a reset voltage Vcm and b) first and second logic switches 318 and 319 to connect the first input code and the second input code to a reset code, respectively. The reset code is a fixed value.

To place the analog-to-digital converter 300 in the chopping mode, the controller 304 may control the control signal SW in a manner that causes the first refresh switch 311 to electrically connect the first capacitor C31 to the input signal V(p) and electrically connect the second capacitor C32 to the input signal V(n) while simultaneously causing a) the second refresh switch 312 to electrically disconnect C31, C32 and DACs 313, 314 from the reset voltage Vcm and b) first and second logic switches 318 and 319 to connect first DAC 313 first input code to signal (doutlp) and DAC 314 second input code to signal (dout1n).

During the chopping mode, the controller 304 may oscillate the chop signal fc at the chopping rate in a manner that causes the input chopper 303 to toggle between electrically connecting the non-inverting input of the comparator 315 to the input signal V(p) and the input signal V(n) through the first capacitor C31 and the first refresh switch 311. During the chopping mode, the controller 304 may oscillate the chop signal fc in a manner that causes the input chopper 303 to toggle between electrically connecting the inverting input of the comparator 315 to the input signal V(p) and the input signal V(n) through the second capacitor C32 and the first refresh switch 311.

The first DAC 313 and the second DAC 314 may each be a capacitive digital-to-analog converter. The first DAC 313 and the second DAC 314 may each comprise an array of capacitors, each capacitor in the array having a value that may be a binary multiple of a unit capacitance. Binary weighting of the capacitors may allow for efficient implementation of the digital-to-analog conversion process.

The first DAC 313 may use a first input code from the logic circuit 317 through first logic switch 318 to selectively charge or discharge the capacitors within the first DAC 313. The first input code, which may control the charging and discharging of specific capacitors in the array of capacitors, may be binary representations of the first input code. The first DAC 313 may use the first input code to selectively charge or discharge the capacitors within the first DAC 313. The first DAC 313 may operate by selectively charging or discharging the capacitors based on the first input code, resulting in a redistribution of electrical charges between capacitors in the capacitor array of the first DAC 313. By selectively charging or discharging the capacitors, the first DAC 313 may produce a first analog output voltage that may be proportional to the first input code.

Summing junction sj31 connects the output from the first DAC 313 directly to the non-inverting input of the comparator 315 and a first non-inverting input of the amplifier 321 as illustrated in the example of FIG. 3. For instance, summing junction sj31 may include one or more wires or conductive traces that link together various components of the analog-to-digital converter 300. Summing junction sj31 may combine the first analog output voltage with the input signal V(p) that has been capacitively-coupled through capacitor C31. The resulting intermediate signal p(+) may represent the weighted sum of the input signal V(p) and the first analog output voltage.

The second DAC 314 may use a second input code from the logic circuit 317 through second logic switch 319 to selectively charge or discharge the capacitors within the second DAC 314. The second input code, which may control the charging and discharging of specific capacitors in the array of capacitors, may be binary representations of the second input code. The second DAC 314 may use the second input code to selectively charge or discharge the capacitors within the second DAC 314. The second DAC 314 may operate by selectively charging or discharging the capacitors based on the second input code, resulting in a redistribution of electrical charges between capacitors in the capacitor array of the second DAC 314. By selectively charging or discharging the capacitors, the second DAC 314 may produce a second analog output voltage that may be proportional to the second input code.

Summing junction sj32 may wire an output from the second DAC 314 directly to the inverting input of the comparator 315 and a first inverting input of the amplifier 321 as illustrated in the example of FIG. 3. For instance, summing junction sj32 may include one or more wires or conductive traces that link together various components of the analog-to-digital converter 300. Summing junction sj32 may combine the second analog output voltage with the input signal V(n) that has been capacitively-coupled through capacitor C32. The resulting intermediate signal n(-) may represent the weighted sum of the input signal V(n) and the second analog output voltage.

The first DAC 313 and second DAC 314 may work together to implement a first differential arrangement where two complementary signals p(+) and n(-) represent the analog value the difference of the input signals V(p) and V(n) and the first and second input codes, with intermediate signal p(+) being the positive component of the differential signal and intermediate signal n(-) being the negative component of the differential signal. The term "common-mode rejection" may refer to the ability of the differential arrangement to suppress noise and interference that affects both the positive and negative sides of the signal equally, thereby improving the signal-to-noise ratio and accuracy of the analog-to-digital conversion process. This first differential arrangement may help improve the common-mode rejection and the overall performance of the analog-to-digital converter 300.

Comparator 315 is an electronic component that may receive intermediate signal p(+) at the non-inverting input and intermediate signal n(-) at the inverting input and may compare intermediate signal p(+) against intermediate signal n(-). Comparator 315 may produce a digital output indicating which of the intermediate signals p(+), n(-) is larger. The digital output may be a differential output, which may provide complementary logic levels indicating the result of the comparison. This comparison may produce a bistable signal with two distinct states: a high state where intermediate signal p(+) may exceed intermediate signal n(-), and a low state where intermediate signal p(+) may be less than or equal to intermediate signal n(-). The bistable signal may comprise a bitstream. A data width of the bitstream may comprise a single bit. The logic level for the bit may correspond to either the high state or the low state.

The digital chopper 316 is an electronic component that may perform a dechopping process. The dechopping process may reverse the effects of chopping by the input chopper 303. The clock signal fc may control the digital chopper 316 to synchronize the digital chopper 316 with the input chopper 303, ensuring proper signal reconstruction. This dechopping process may demodulate the amplified intermediate signals p(+), n(-), potentially shifting the amplified intermediate signals p(+), n(-) back to their original frequency band while modulating any low-frequency noise and DC offsets injected between the input chopper 303 and the digital chopper 316 to higher frequencies.

The digital chopper 316 may feed the comparator output or its complementary to the logic circuit 317. The logic circuit 317 may process the bistable signal and control the DACs 313-314 accordingly.

The second module 302 may include an amplifier 321 and an output chopper 322. The second module 302 may include additional components. For instance, although not shown in FIG. 3, the second module 302 may include adder ad1, adder ad2 and the ADC circuit 123 of the second module 102. Likewise, digital gain circuit 106, the DEF circuit 107, the delay circuit 108 and digital adders ad3, ad4 from the analog-to-digital converter 100 although not shown in FIG. 3.

The amplifier 321 may receive a pair of signals p(+), n(-) and output a pair of differential intermediate signals a(+), a(-). As depicted in FIG. 3, inputs of the amplifier 321 are wired directly to the inputs of the comparator 315 so that the inputs of the amplifier 321 may receive the intermediate signal pair p(+), n(-). For instance, a non-inverting input of amplifier 321 may receive intermediate signal p(+) while an inverting input of amplifier 321 may receive intermediate signal n(-). The intermediate signal pair p(+), n(-) in the example of FIG. 3 may be a pair of differential signals.

The output chopper 322 is an electronic component that may perform a dechopping process. The dechopping process may reverse the effects of chopping by the input chopper 303. The clock signal fc may control the output chopper 322 to synchronize the output chopper 322 with the input chopper 303, ensuring proper signal reconstruction. This dechopping process may demodulate the amplified differential signals a(+), a(-), potentially shifting the amplified differential signals a(+), a(-) back to their original frequency band while modulating any low-frequency noise and DC offsets injected between the input chopper 303 and the output chopper 322 to higher frequencies. For instance, the output chopper 322 may sample the amplified differential signals a(+), a(-) at specific time intervals, converting the amplified differential signals a(+), a(-) into discrete-time samples for processing by the ADC circuit 123 of FIG. 1. The output chopper 322 may feed the sampled signals to the ADC circuit 123 in the form of positive and negative differential signals (p), (n).

When an element is referred to herein as being "connected" or "coupled" to another element, it is to be understood that the elements can be directly connected to the other element, or have intervening elements present between the elements.

Certain operations of methods described in this technology, or systems executing those methods, may be schematically represented in figures or textual descriptions. Unless explicitly stated, the spatial arrangement of operations in figures does not necessarily dictate the sequence in which they must be performed. Operations may be executed in a different order than illustrated, depending on implementation requirements. Additionally, certain operations may be performed in parallel or partially in parallel, utilizing dedicated parallel processing devices or separate computing systems that interoperate within a larger system.

The term "or," unless otherwise defined or limited, denotes a non-exclusive list, allowing various combinations of listed elements rather than restricting them to mutually exclusive alternatives. For example, a list including "A, B, or C" may encompass A alone, B alone, C alone, any combination of two elements, or all three elements together. Exclusivity applies only when expressly stated using terms such as "either," "only one of," or "exactly one of." Similarly, lists preceded by phrases such as "one or more of" or "at least one of" indicate the possibility of multiple occurrences of any or all listed elements. A list introduced by "a plurality of" or "two or more of" suggests multiple instances of any or all elements. The term "or" should only be interpreted as exclusive when explicitly specified by contextual qualifiers.

The articles "a," "an," and "the" generally encompass both singular and plural forms unless explicitly stated otherwise. The terms "comprises," "includes," and "has" indicate the presence of stated features, components, operations, or elements while not excluding additional features, components, or combinations thereof.

Throughout this document, ordinal numbers such as "first," "second," and "third" may be used to describe various elements. These terms serve solely to distinguish elements from one another rather than imply a specific sequence, hierarchy, or limitation on quantity. Ordinal numbers do not necessarily dictate an order unless explicitly modified by terms such as "before," "after," or "single." A first element is distinct from a second element, and the first element may contain multiple components or appear before or after the second element in a given arrangement. The designation of ordinal numbers may be interchangeable without altering the scope of the described examples.

Any trademarks referenced herein may be common law or registered trademarks of third parties affiliated or unaffiliated with the applicant or assignee. These references are provided for illustrative purposes only and should not be interpreted as limiting the disclosed embodiments to material associated exclusively with those trademarks.

The invention further comprises the following embodiments forming part of the description:
1. An apparatus comprising:
   a first module comprising a comparator, a first digital-to-analog converter and a second digital-to-analog converter; and
   a second module comprising an amplifier,
   wherein an output from the first digital-to-analog converter is wired directly to a first differential input of the comparator and a first differential input of the amplifier, and
   wherein an output from the second digital-to-analog converter is wired directly to a second differential input of the comparator and a second differential input of the amplifier.
2. The apparatus of embodiment 1, further comprising:
   a switch configured to electrically connect, to a voltage, the first differential input of the comparator and the second differential input of the comparator.
3. The apparatus of embodiment 2, wherein the switch is configured to disconnect, from the voltage, the first differential input of the comparator and the second differential input of the comparator.
4. The apparatus of embodiment 2, further comprising:
   a first capacitor wired directly to the output from the first digital-to-analog converter.
5. The apparatus of embodiment 4, wherein the switch is configured to electrically connect, while connecting the first differential input of the comparator and the second differential input of the comparator to the voltage, the first capacitor to the voltage.
6. The apparatus of embodiment 4, wherein the switch is configured to disconnect, while disconnecting the first differential input of the comparator and the second differential input of the comparator from the voltage, the first capacitor from the voltage.
7. The apparatus of embodiment 4, further comprising:
   a second capacitor wired directly to the output from the second digital-to-analog converter.
8. The apparatus of embodiment 7, wherein the switch is configured to electrically connect, while connecting the second differential input of the comparator and the second differential input of the comparator to the voltage, the second capacitor to the voltage.
9. The apparatus of embodiment 7, wherein the switch is configured to disconnect, while disconnecting the second differential input of the comparator and the second differential input of the comparator from the voltage, the second capacitor from the voltage.
10. The apparatus of embodiment 9, further comprising:
   a chopper electrically connected to the first capacitor, the first capacitor being wired between the comparator and the chopper.
11. The apparatus of embodiment 10, wherein the chopper is configured to electrically connect and disconnect, in an alternating sequence, the first capacitor to and from an input signal.
12. The apparatus of embodiment 11, further comprising:
   an output chopper configured to electrically connect and disconnect, in sequence with the chopper, an output from the amplifier to an adder.
13. The apparatus of embodiment 1, wherein the second module is configured to perform, in response to the first and second differential inputs of the amplifier receiving an intermediate signal pair, the intermediate signal pair into a binary code.
14. A system comprising:
   a controller configured to repetitively alternate the system between a refresh mode and a chopping mode; and
   a first module comprising a switch and a comparator,
   wherein the switch is configured to:
      electrically connect, to a voltage while the system is in the refresh mode, a first differential input of the comparator and a second differential input of the comparator, and
      disconnect, from the voltage while the system is in the chopping mode, the first differential input of the comparator and the second differential input of the comparator.
15. The system of embodiment 14, wherein the switch is configured to electrically connect, while connecting the first differential input of the comparator and the second differential input of the comparator to the voltage, a capacitor to the voltage.
16. The system of embodiment 14, wherein the comparator is configured to convert, in response to the first and second differential inputs of the comparator receiving an intermediate signal pair, the intermediate signal pair into a bistable signal.
17. The system of embodiment 14, further comprising:
   a second module comprising an amplifier,
   wherein the second module is configured to perform, in response to the first and second differential inputs of the amplifier receiving an intermediate signal pair, the intermediate signal pair into a binary code.
18. The system of embodiment 17, wherein:
   the first module comprises a first digital-to-analog converter and a second digital-to-analog converter,
   wherein an output from the first digital-to-analog converter is wired directly to the first differential input of the comparator and the first differential input of the amplifier.
19. The system of embodiment 18, wherein an output from the second digital-to-analog converter is wired directly to a second differential input of the comparator and a second differential input of the amplifier.
20. A method comprising:
   alternating, repetitively by a controller, an apparatus between a refresh mode and a chopping mode;
   electrically connecting, by a switch while the apparatus is in the refresh mode, a first differential input of a comparator and a second differential input of the comparator to a voltage; and
   disconnecting, by the switch while the apparatus is in the chopping mode, the first differential input of the comparator and the second differential input of the comparator from the voltage.

## Claims

1. An apparatus comprising:
a first module comprising a comparator, a first digital-to-analog converter and a second digital-to-analog converter; and
a second module comprising an amplifier,
wherein an output from the first digital-to-analog converter is wired directly to a first differential input of the comparator and a first differential input of the amplifier, and
wherein an output from the second digital-to-analog converter is wired directly to a second differential input of the comparator and a second differential input of the amplifier.

2. The apparatus according to claim 1, further comprising:
a switch configured to electrically connect, to a voltage, the first differential input of the comparator and the second differential input of the comparator.

3. The apparatus according to claim 2, wherein the switch is configured to disconnect, from the voltage, the first differential input of the comparator and the second differential input of the comparator.

4. The apparatus according to claim 2, further comprising:
a first capacitor wired directly to the output from the first digital-to-analog converter.

5. The apparatus according to claim 4, wherein the switch is configured to electrically connect, while connecting the first differential input of the comparator and the second differential input of the comparator to the voltage, the first capacitor to the voltage,
and/or
wherein the switch is configured to disconnect, while disconnecting the first differential input of the comparator and the second differential input of the comparator from the voltage, the first capacitor from the voltage.

6. The apparatus according to claim 4, further comprising:
a second capacitor wired directly to the output from the second digital-to-analog converter, and
wherein the switch is in particular configured to electrically connect, while connecting the second differential input of the comparator and the second differential input of the comparator to the voltage, the second capacitor to the voltage.

7. The apparatus according to claim 6, wherein the switch is configured to disconnect, while disconnecting the second differential input of the comparator and the second differential input of the comparator from the voltage, the second capacitor from the voltage.

8. The apparatus according to claim 7, further comprising:
a chopper electrically connected to the first capacitor, the first capacitor being wired between the comparator and the chopper.

9. The apparatus according to claim 8, wherein the chopper is configured to electrically connect and disconnect, in an alternating sequence, the first capacitor to and from an input signal, and the apparatus in particular further comprising:
an output chopper configured to electrically connect and disconnect, in sequence with the chopper, an output from the amplifier to an adder.

10. The apparatus according to claim 1, wherein the second module is configured to perform, in response to the first and second differential inputs of the amplifier receiving an intermediate signal pair, the intermediate signal pair into a binary code.

11. A system comprising:
a controller configured to repetitively alternate the system between a refresh mode and a chopping mode; and
a first module comprising a switch and a comparator,
wherein the switch is configured to:
electrically connect, to a voltage while the system is in the refresh mode, a first differential input of the comparator and a second differential input of the comparator, and
disconnect, from the voltage while the system is in the chopping mode, the first differential input of the comparator and the second differential input of the comparator.

12. The system according to claim 11, wherein the switch is configured to electrically connect, while connecting the first differential input of the comparator and the second differential input of the comparator to the voltage, a capacitor to the voltage,
and/or
wherein the comparator is configured to convert, in response to the first and second differential inputs of the comparator receiving an intermediate signal pair, the intermediate signal pair into a bistable signal.

13. The system according to claim 11, further comprising:
a second module comprising an amplifier,
wherein the second module is configured to perform, in response to the first and second differential inputs of the amplifier receiving an intermediate signal pair, the intermediate signal pair into a binary code.

14. The system according to claim 13, wherein:
the first module comprises a first digital-to-analog converter and a second digital-to-analog converter,
wherein an output from the first digital-to-analog converter is wired directly to the first differential input of the comparator and the first differential input of the amplifier, and
wherein an output from the second digital-to-analog converter is in particular wired directly to a second differential input of the comparator and a second differential input of the amplifier.

15. A method comprising:
alternating, repetitively by a controller, an apparatus between a refresh mode and a chopping mode;
electrically connecting, by a switch while the apparatus is in the refresh mode, a first differential input of a comparator and a second differential input of the comparator to a voltage; and
disconnecting, by the switch while the apparatus is in the chopping mode, the first differential input of the comparator and the second differential input of the comparator from the voltage.
